# EUROPEAN PATENT SPECIFICATION

(11) **EP 2 981 161 B1**
(45) Date of publication and mention of the grant of the patent: **12.12.2018**
(21) Application number: 13880447.1
(22) Date of filing: 29.03.2013
(51) Int. Cl.: H05K 13/02, H05K 13/08

(54) **FEEDER POWER SUPPLY CONTROL DEVICE AND METHOD THEREFOR**
STROMVERSORGUNGSSTEUERUNGSVORRICHTUNG FÜR EINE ZUFÜHREINHEIT UND VERFAHREN DAFÜR
DISPOSITIF DE COMMANDE D'ALIMENTATION D'ÉLÉMENT D'ALIMENTATION ET PROCÉDÉ POUR CELUI-CI

(43) Date of publication of application: 03.02.2016
(73) Proprietor: FUJI Corporation, Chiryu Aichi (JP)
(72) Inventor: KAWAI, Takuro, Chiryu-shi Aichi 472-8686 (JP); AOKI, Takeshi, Chiryu-shi Aichi 472-8686 (JP)
(74) Representative: Grünecker Patent- und Rechtsanwälte PartG mbB
(86) International application number: PCT/JP2013/059533
(87) International publication number: WO 2014/155669

(56) References cited:
- JP-A- 2000 307 297
- JP-A- 2003 264 399
- JP-A- 2008 098 355
- JP-A- 2008 098 355
- US-B1- 6 701 611

## Description

### Technical Field

The present invention relates to a feeder power supply control device and a feeder power supply control method.

### Background Art

A component mounting machine known in the related art mounts an electronic component on a desired position a printed circuit board by attaching the electronic component with suction to a tip end of a suction nozzle using negative pressure, moving a head provided with the suction nozzle to predetermined coordinates on the printed circuit board, and applying positive pressure to the tip end of the suction nozzle at the position. The electronic component that is attached with suction to the tip end of the suction nozzle, for example, is supplied in a collectible manner on a tape that is transported one pitch at a time by an electric tape feeder. Supply of power to the tape feeder is desirably suppressed to the minimum extent necessary to save energy. From such a viewpoint, in PTL 1, there is suggested a device that places a motor of the tape feeder into a power saving mode when a period of time during which an operation of supplying a component from the tape feeder is not scheduled is longer than or equal to a predetermined period of time.EP

PTL 2 discloses features defined in the preamble of claims 1 and 5.

### Citation List

### Patent Literature

PTL 1: JP-A-2008-98355
PTL 2: US 6 701 611 B1

### Summary of Invention

### Technical Problem

An arising problem, however, is that the device of PTL 1 above lacks simplicity because it is necessary to obtain the period of time during which an operation of supplying a component from the tape feeder is not scheduled.

The invention is devised to resolve such a problem, and a main object thereof is to realize a reduction in the power consumption of a feeder in a simple manner.

### Solution to Problem

According to an aspect of the invention, there is provided a feeder power supply control device that controls power supply of an electric feeder which sequentially supplies components to a component mounting machine, the device including: determining means for determining whether the feeder is used in a current production; and controlling means for reducing power supplied to the feeder that has no possibility of being used in the current production in comparison with the feeder that is used in the current production.

In the feeder power supply control device, supply of power to the feeder that has no possibility of being used in the current production is reduced in comparison with the feeder that is used in the current production. Thus, in the reduction of supply of power, it is not necessary to obtain a period of time during which an operation of supplying components from the feeder is not scheduled as in the related art. Therefore, a reduction in the power consumption of the feeder can be realized in a simple manner.

In the feeder power supply control device according to the invention, the controlling means may set the feeder that is used in the current production into a non-power saving mode in which the feeder is capable of supplying components in response to a component supply instruction and may set the feeder that has no possibility of being used in the current production into a power saving mode in which power supplied is low in comparison with the non-power saving mode. By doing so, the feeder that is used in the current production can promptly supply components to the component mounting machine in response to the component supply instruction.

In the feeder power supply control device according to the invention, the controlling means, when there is a feeder that supplies the same components as the feeder that is used in the current production among the feeders, may set the feeder that is used in the current production as a master feeder that immediately supplies components to the component mounting machine, may set the feeder that supplies the same components as the master feeder as a spare feeder that is used as a spare when components of the master feeder run out and that has a possibility of being used in the current production, may set the spare feeder into the power saving mode, and may change the mode of the spare feeder to the non-power saving mode immediately before components of the master feeder run out and then may change the mode of the master feeder to the power saving mode when components of the master feeder run out. By doing so, switching to the spare feeder can be smoothly performed when components of the master feeder run out, and power consumption of a used master feeder can be suppressed.

In the feeder power supply control device according to the invention, the power saving mode may be a mode in which all power supplies to the feeders are switched OFF. By this, the effect of saving power is high because the feeder that is not used in the current production does not consume power.

According to another aspect of the invention, there is provided a feeder power supply control method for controlling power supply of an electric feeder that sequentially supplies components to a component mounting machine, the method including: a step of determining whether the feeder is used in a current production; and a step of reducing power supplied to a feeder that has no possibility of being used in the current production in comparison with a feeder that is used in the current production.

In the feeder power supply control method for controlling power supply of a feeder, supply of power to the feeder that has no possibility of being used in the current production is reduced in comparison with the feeder that is used in the current production. Thus, in the reduction of supply of power, it is not necessary to obtain a period of time during which an operation of supplying components from the feeder is not scheduled as in the related art. Therefore, a reduction in the power consumption of the feeder can be realized in a simple manner.

### Brief Description of Drawings

[Fig. 1] Fig. 1 is a schematic descriptive view of a component mounting system 1.
[Fig. 2] Fig. 2 is a perspective view of a component mounting machine 11.
[Fig. 3] Fig. 3 is a descriptive view of a reel unit 70.
[Fig. 4] Fig. 4 is a flowchart illustrating an example of a mode setting routine of a first embodiment.
[Fig. 5] Fig. 5 is a flowchart illustrating an example of a component supply process routine of the first embodiment.
[Fig. 6] Fig. 6 is a flowchart illustrating an example of a mode setting routine of a second embodiment.
[Fig. 7] Fig. 7 is a flowchart illustrating an example of a component supply process routine of the second embodiment.
[Fig. 8] Fig. 8 is a flowchart illustrating an example of a component runout measure process routine of the second embodiment.
[Fig. 9] Fig. 9 is a flowchart illustrating an example of a component runout measure process routine of a third embodiment.

### Description of Embodiments

### [First Embodiment]

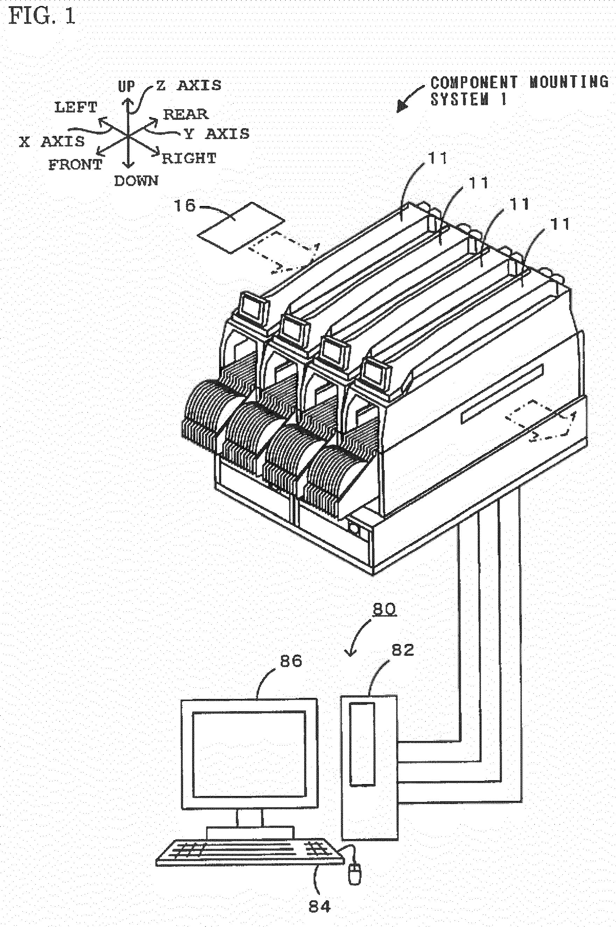

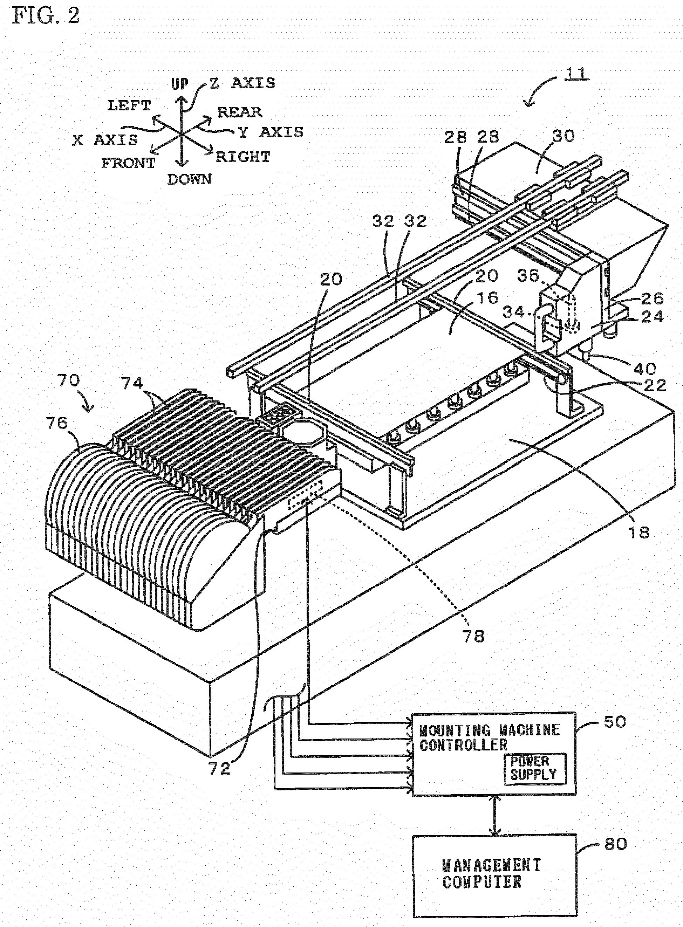

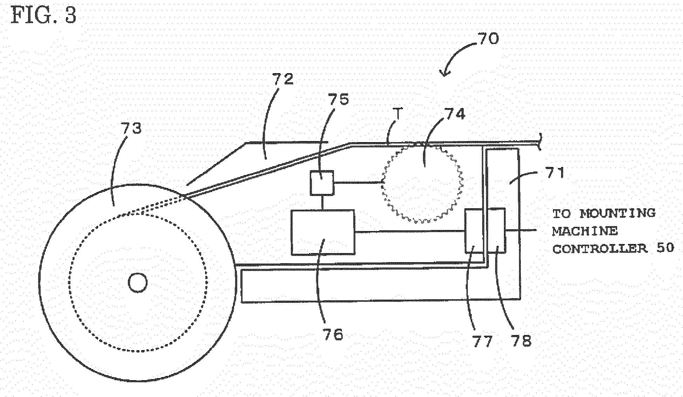

Hereinafter, exemplary embodiments of the invention will be described with reference to the drawings. Fig. 1 is a schematic descriptive view of a component mounting system 1, Fig. 2 is a perspective view of a component mounting machine 11, and Fig. 3 is a descriptive view of a reel unit 70. In the present embodiment, a left-right direction (X axis), a front-rear direction (Y axis), and an up-down direction (Z axis) are set as illustrated in Fig. 1 and Fig. 2.

The component mounting system 1 is provided with a plurality of component mounting machines 11, the reel unit 70, and a management computer 80. The plurality of component mounting machines 11 forms a mounting line. The reel unit 70 supplies components to the component mounting machines 11. The management computer 80 manages production of printed circuit boards.

The component mounting machine 11, as illustrated in Fig. 2, is provided with a board conveyance device 18, a head 24, a suction nozzle 40, and a mounting machine controller 50. The board conveyance device 18 conveys a printed circuit board 16. The head 24 is movable on the XY plane. The suction nozzle 40 is movably attached to the head 24 in a Z-axis. The mounting machine controller 50 performs various controls. The board conveyance device 18 conveys the printed circuit board 16 from the left to the right with conveyor belts 22 and 22 (only one is illustrated in Fig. 2) that are respectively installed on a left and right pair of supporting boards 20 and 20. The head 24 moves in the left-right direction along with the movement of an X-axis slider 26 in the left-right direction along guide rails 28 and 28 and moves in the front-rear direction along with the movement of a Y-axis slider 30 in the front-rear direction along guide rails 32 and 32. The suction nozzle 40 uses pressure to attach a component with suction to a nozzle tip end or to detach a component that is attached with suction to the nozzle tip end. The height of the suction nozzle 40 is adjusted by a Z-axis motor 34 and a ball screw 36. The Z-axis motor 34 is incorporated into the head 24. The ball screw 36 extends along the Z axis. The mounting machine controller 50 is configured as a microprocessor mainly with a CPU and is connected with the board conveyance device 18, the X-axis slider 26, the Y-axis slider 30, and the head 24 such that signals can be exchanged therebetween.

The reel unit 70 is mounted at the front of the component mounting machine 11 as illustrated in Fig. 2. The reel unit 70 includes a plurality of slots 71, and a feeder 72 is configured to be insertable into each of the slots 71. As illustrated in Fig. 3, the feeder 72 includes a feeder connector 77 at the rear thereof. The feeder connector 77 is electrically connected with a slot connector 78 in a state where the feeder 72 is inserted into the slots 71. A reel 73 around which a tape T is wound is installed in the feeder 72. Components are held on the surface of the tape T while being lined up in the longitudinal direction of the tape. These components are protected by a film that covers the surface of the tape T. Such a tape T is transported along with the rotation of a sprocket 74 by a motor 75 in a state where teeth of the sprocket 74 mesh with holes that are open along the longitudinal direction of the tape T, and the tape T is arranged at a predetermined position in a state where a component is exposed after the film is peeled. The predetermined position is a position where the suction nozzle 40 can attach the component thereto with suction. Since the suction nozzle 40 that attaches the component thereto with suction at the predetermined position can move in the directions of X, Y, and Z, the component can be mounted at a predetermined position on the printed circuit board 16. The motor 75 is controlled by a feeder controller 76 that is incorporated into the feeder 72. The feeder controller 76 that is incorporated into each feeder 72 is connected in a bidirectionally communicable manner with the mounting machine controller 50 through the feeder connector 77 and the slot connector 78. Supply of power to the feeder 72 is performed by the mounting machine controller 50 through the feeder connector 77 and the slot connector 78 by using two lines of a power line to the feeder controller 76 and a power line to the motor 75.

The management computer 80 is provided with a personal computer main body 82, an input device 84, and a display 86. Signals from the input device 84 that is operated by an operator can be input into the management computer 80, and various images can be output to the display 86. A memory of the personal computer main body 82 stores production job data for the printed circuit board 16. In the production job data, there are defined which component is to be mounted on which type of printed circuit board 16 in which order from which slot position of the feeder in each component mounting machine 11 in addition to how many pieces of the printed circuit boards 16 on which mounting is finished are to be manufactured. Tables 1 and 2 respectively illustrate examples of the production job data in the current production and in the next production. In the production job of the current production, mounting is performed on 100 pieces of type α printed circuit boards 16 in the following order. First, supply of a type A component is received from the feeder 72 that is inserted into a slot position #1 of the reel unit 70. Next, supply of a type B component is received from the feeder 72 that is inserted into a slot position #5. Next, supply of a type C component is received from the feeder 72 that is inserted into a slot position #9. The production job of the next production is a job in which components are mounted in order on a type β printed circuit board 16. The production job of the next production is moved up to the production job of the current production after the production job of the current production ends. The management computer 80 is connected with the mounting machine controller 50 of each component mounting machine 11 in a bidirectionally communicable manner.

**[Table 1]**

| [Current Production] | | |
|---|---|---|
| Production Job Data (Number of Pieces of Boards: 100, Board Type: α) | | |
| Slot Position | Component Type | Mounting Order |
| #1 | A | First |
| #5 | B | Second |
| #9 | C | Third |

**[Table 2]**

| [Next Production] | | |
|---|---|---|
| Production Job Data (Number of Pieces of Boards: 100, Board Type: β) | | |
| Slot Position | Component Type | Mounting Order |
| #1 | A | First |
| #5 | B | Second |
| #2 | D | Third |

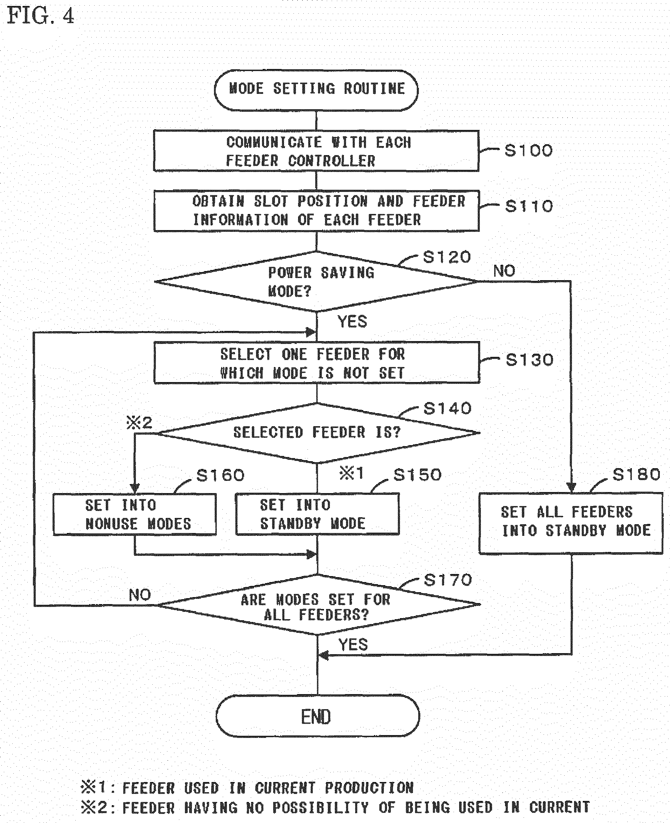

Next, saving power consumed in the feeder 72 will be described. Fig. 4 is a flowchart illustrating an example of a mode setting routine that the mounting machine controller 50 performs. The feeder 72 that is necessary at the slot position of the current production is inserted into the reel unit 70 by the operator. The production job data of the current production here is assumed to be the one illustrated in Table 1. In addition, five feeders 72 of feeder numbers from 01 to 05 are assumed to be prepared. The feeder controller 76 of each feeder 72 stores a feeder number, a component type, and the number of components held (the number of components held on the tape T that is wound around the reel 73) as feeder information on an internal memory. An example of the feeder information is illustrated in Table 3. The operator sets each feeder 72 to the slots 71 on the basis of the production job. In accordance with the production job data of the current production in Table 1, the feeder 72 of the feeder number 01 is set to the slot position #1, the feeder 72 of the feeder number 02 to the slot position #5, and the feeder 72 of the feeder number 03 to the slot position #9. Since the feeder 72 of the feeder number 04 is used in the next production as illustrated in Table 2, the feeder 72 of the feeder number 04 is set to a slot position #2 in accordance with the production job data of the next production. The feeder 72 of the feeder number 05 is set to an arbitrary position. The feeder 72 of the feeder number 05 is assumed to be set to a slot position #6.

**[Table 3]**

| Feeder Information | | |
|---|---|---|
| Feeder Number | Component Type | Number of Components Held |
| 01 | A | 100 |
| 02 | B | 100 |
| 03 | C | 100 |
| 04 | D | 100 |
| 05 | A | 100 |

The operator sets the feeders 72 to the slots 71 on the basis of the production job data of the current production and the feeder information and then switches a not-illustrated mode setting start button of the component mounting machine 11 ON. Then, the mounting machine controller 50 reads the mode setting routine from the internal memory and performs the mode setting routine. The mounting machine controller 50, when receiving new production job data from the management computer 80, resets the mode that was set previously and waits for the time when the mode setting start button is switched ON again.

The mounting machine controller 50, when the mode setting routine starts, supplies power to the feeder controller 76 that is incorporated into each feeder 72 and performs bidirectional communication (step S100) and obtains the slot position and the feeder information of each feeder 72 and retains a relationship between the slot position and the feeder information in the internal memory (step S110). An example of the relationship between the slot position and the feeder information is illustrated in Table 4. The feeders 72 are not inserted into slot positions that are not illustrated in Table 4.

**[Table 4]**

| Slot Position | Feeder Information | | |
|---|---|---|---|
| | Feeder Number | Component Type | Number of Components Held |
| #1 | 01 | A | 100 |
| #2 | 04 | D | 100 |
| #5 | 02 | B | 100 |
| #6 | 05 | A | 100 |
| #9 | 03 | C | 100 |

| | | | |
|---|---|---|---|
| *Cells in gray indicate slot positions and feeders that are not registered in the production job data. | | | |

Next, the mounting machine controller 50 determines whether a power saving mode is set in the component mounting machine 11 (step S120) . The power saving mode is set when the operator selects a not-illustrated power saving button in the component mounting machine 11.

When the power saving mode is not set in step S120, all of the feeders 72 that are inserted into the slots 71 are set to a standby mode (step S180), and the routine ends. The standby mode is a mode in which the feeder 72 stands by so that components can be supplied in response to a component supply instruction from the mounting machine controller 50. The standby mode is an example of a non-power saving mode of the invention. In the standby mode, the component mounting machine 11 supplies power to the feeder controller 76 but does not supply power to the motor 75.

Meanwhile, when the power saving mode is set in step S120, the mounting machine controller 50 selects one of the feeders 72 for which a mode is not set (step S130). The feeders 72 are assumed to be selected in order from the smallest feeder number. Next, a determination of whether the feeder 72 selected is used in the current production is performed (step S140) . This determination is performed by determining whether the slot position of the selected feeder 72 is registered in the production job data of the current production in correlation with a component type. When the feeder 72 selected in step S140 is used in the current production, the feeder 72 is set to the standby mode (step S150). When the feeder 72 selected in step S140 has no possibility of being used in the current production, the feeder 72 is set to a nonuse mode (step S160) . When, for example, the feeder 72 selected is the feeder 72 of the feeder number 01, the feeder 72 is determined to be used in the current production and is set to the standby mode because the slot position #01 of the feeder 72 is registered in the production job data of the current production in correlation with the component type A. Meanwhile, when the feeder 72 selected is the feeder 72 of the feeder number 04, the feeder 72 is determined to have no possibility of being used in the current production and is set to the nonuse mode because the slot position #02 of the feeder 72 is not registered in the production job data of the current production in correlation with a component type D. In the nonuse mode, the component mounting machine 11 does not supply power to both of the feeder controller 76 and the motor 75. That is, all power supplies of the feeders 72 are switched OFF. Thus, the power supplied to the feeders 72 in the nonuse mode is smaller than the power supplied to the feeders 72 in the standby mode. The nonuse mode is an example of a power saving mode of the invention.

The mounting machine controller 50, after step S150 or step S160, determines whether modes are set for all of the feeders 72 that are mounted on the reel unit 70 (step S170). When there remains a feeder 72 for which a mode is not set in step S170, the processes from step S130 are performed again. When mode setting is completed for all of the feeders 72 mounted on the reel unit 70 in step S170, the routine ends.

After the mode setting routine ends, the feeders 72 of the feeder numbers 01, 02, and 03 that are respectively inserted into the slot positions #1, #5, and #9 are set to the standby mode, and the feeders 72 of the feeder numbers 04 and 05 that are respectively inserted into the slot positions #2 and #6 are set to the nonuse mode.

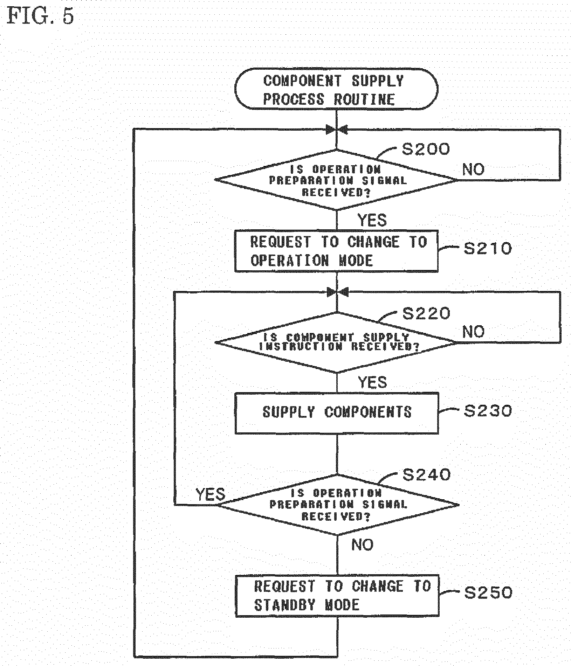

Next, a component supply process routine that is performed by the feeder controller 76 will be described. Fig. 5 is a flowchart illustrating an example of the component supply process routine. The feeder controller 76, after being set to the standby mode, can perform this routine so as to continuously receive a supply of power from the component mounting machine 11. The feeder controller 76 that is set to the nonuse mode does not perform this routine because power is not supplied from the component mounting machine 11.

When the component supply process routine starts, the feeder controller 76 first determines whether an operation preparation signal is received from the mounting machine controller 50 (step S200). When the operation preparation signal is received, the feeder controller 76 transmits a request to the mounting machine controller 50 to change the mode of the feeder 72 to an operation mode (step S210). The operation preparation signal is a signal that prompts preparation of component supply and is specifically a signal for setting the feeder 72 to the operation mode. The mounting machine controller 50 that receives this change request supplies power to both of the feeder controller 76 and the motor 75 and places the feeder 72 into the operation mode. The operation mode is a mode in which the feeder 72 can immediately supply components in response to the component supply instruction from the mounting machine controller 50. The operation mode is an example of the non-power saving mode of the invention.

Next, the feeder controller 76 determines whether the component supply instruction signal is received from the mounting machine controller 50 (step S220) and stands by when the signal is not received or performs supply of components after the signal is received (step S230). Supply of components is performed by controlling the motor 75 such that components on the tape T are supplied to a predetermined position through the rotation of the sprocket 74. After supply of components is performed, the feeder controller 76 determines whether a next operation preparation signal is received from the mounting machine controller 50 (step S240) and returns to step S220 when the next operation preparation signal is received. Accordingly, when the component mounting machine 11 continuously receives a supply of components from the feeder 72, the feeder 72 is continuously in the operation mode.

Meanwhile, when the next operation preparation signal is not received from the mounting machine controller 50 in step S240, the feeder controller 76 transmits a request to the mounting machine controller 50 to change the mode of the feeder 72 to the standby mode (step S250) and returns to step S200 again. Then, the mounting machine controller 50 that receives this change request only supplies power to the feeder controller 76 and stops supplying power to the motor 75. Accordingly, when the component mounting machine 11 does not continuously receive a supply of components from the feeder 72, the feeder 72 is set to change the mode thereof to the standby mode, and this contributes to power saving. This routine ends when the production job data is updated.

Correspondences between constituent elements of the present embodiment and constituent elements of the invention will be clarified here. The mounting machine controller 50 of the present embodiment corresponds to a feeder power supply control device of the invention. In the present embodiment, an example of the feeder power supply control method of the invention is also clarified through the description of the operation of the mounting machine controller 50.

According to the present embodiment which is described in detail thus far, supply of power to the feeder 72 that has no possibility of being used in the current production is reduced in comparison with the feeder 72 that is used in the current production. Thus, in the reduction of supply of power, it is not necessary to obtain a period of time during which an operation of supplying components from the feeder 72 is not scheduled as in the related art. Therefore, a reduction in the power consumption of the feeder 72 can be realized in a simple manner.

The effect of saving power is high because in the standby mode, the feeder 72 that is used in the current production can promptly perform supply of components to the component mounting machine 11 in response to the component supply instruction, and in the nonuse mode, the feeder 72 that has no possibility of being used in the current production does not consume power.

### [Second Embodiment]

The component mounting system 1 of a second embodiment has the same configuration as the first embodiment. Thus, the configuration of the component mounting system 1 will not be described here, and the same constituent element will be described by using the same reference sign. Also in the second embodiment, the data of Table 1 is assumed to be used as the production job data of the current production.

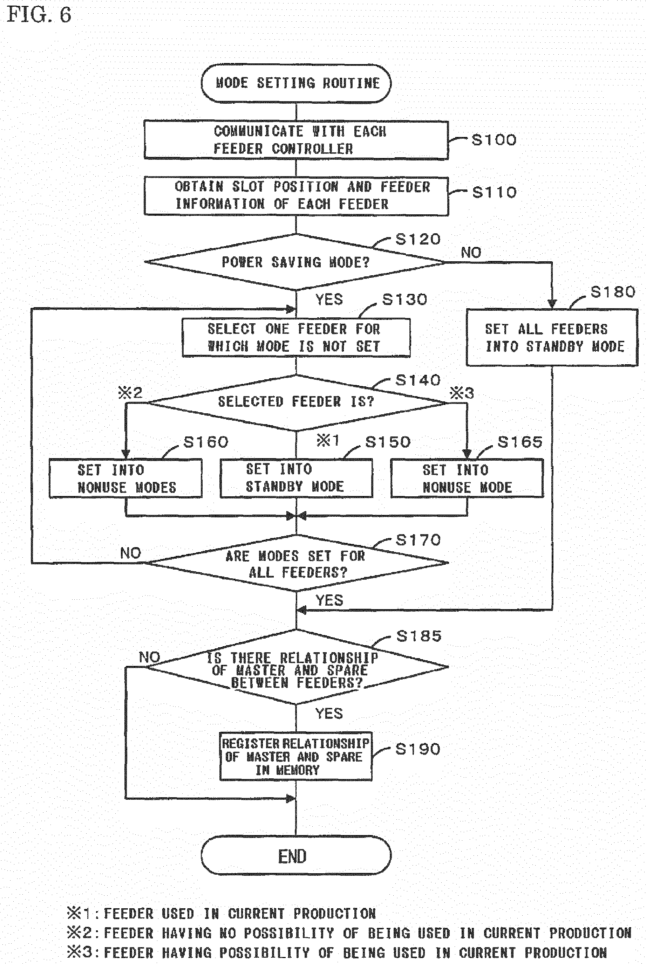

A mode setting routine that is performed by the mounting machine controller 50 will be described by using the flowchart of Fig. 6. This mode setting routine is the same as the mode setting routine of the first embodiment except that steps S110, S140, S165, S185, and S190 are different. Thus, only the steps that are different from the steps of the first embodiment will be described below.

The mounting machine controller 50 is assumed to obtain relationships between slot positions illustrated on the left side of Table 5 and the feeder information in step S110. In step S140, a determination of whether the feeder selected is used in the current production, has no possibility of being used in the current production, or has a possibility of being used in the current production is performed. When the feeder selected is not used in the current production, a determination of whether the feeder holds the same components as the component types used in the current production is performed. When the determination is positive, the feeder is determined to have a possibility of being used in the current production. When the determination is negative, the feeder is determined to have no possibility of being used in the current production. The feeder that is used in the current production is set to the standby mode (step S150), and the feeder that has a possibility or no possibility of being used in the current production is set to the nonuse mode (steps S160 and S165). For example, the feeder 72 of the feeder number 05 that is inserted into the slot position #6 is not immediately used in the current production but is provided with the component type A that is used in the current production. Thus, the feeder 72 of the feeder number 05 is determined to have a possibility of being used in the current production and is set to the nonuse mode.

The mounting machine controller 50, after a positive determination in step S170 or after step S180, determines whether there is a relationship of a master feeder and a spare feeder in the feeders (step S185). When there is such a relationship, the mounting machine controller 50 stores the relationship in the internal memory of the mounting machine controller 50 (step S190) and ends the routine. Specifically, in step S185, when there is a plurality of feeders that hold the same components as the component types used in the current production, among the feeders, the feeder that is registered in the production job data of the current production is recognized as a master feeder, and the feeder that is not registered in the production job data of the current production is recognized as a spare feeder. In step S190, the relationship is registered in the internal memory. When there is not a relationship of a master feeder and a spare feeder in step S185, the routine ends. The spare feeder is a feeder that is determined to have a possibility of being used in the current production in step S140.

The production job data of the current production is the one illustrated in Table 1 as described above, and the number of pieces of printed circuit boards to be produced is assumed to be 100. In this case, components are mounted on the type α printed circuit board 16 in order of the component types A, B, and C in accordance with the relationships between the slot positions illustrated on the left side of Table 5 and the feeder information. However, the feeder 72 of the feeder number 01 that is inserted into the slot position #1 holds only 50 of type A components which is insufficient during the production. The feeder 72 of the feeder number 05 that is inserted into the slot position #6 holds 50 of the same type A components. Thus, when the feeder 72 at the slot position #6 supplies components after the components of the feeder 72 at the slot position #1 run out, 100 pieces of printed circuit boards can be produced. The feeder 72 at the slot position #1 and the feeder 72 at the slot position #6 hold the same type A components, and the former is registered in the production job data of the current production while the latter is not registered. Thus, in step S185, the former is registered as a master feeder, and the latter is registered as a spare feeder (refer to the right side of Table 5).

**[Table 5]**

| | Feeder Information | | | | |
|---|---|---|---|---|---|
| Slot Position | Feeder Number | Component Type | Number of Componen ts Held | | Master or Spare |
| #1 | 01 | A | 50 | | Master |
| #2 | 04 | D | 100 | | - |
| #5 | 02 | B | 100 | | - |
| #6 | 05 | A | 50 | | Spare |
| #9 | 03 | C | 100 | | - |

| | | | | | |
|---|---|---|---|---|---|
| *Cells in gray indicate slot positions and feeders that are not registered in the production job data. | | | | | |

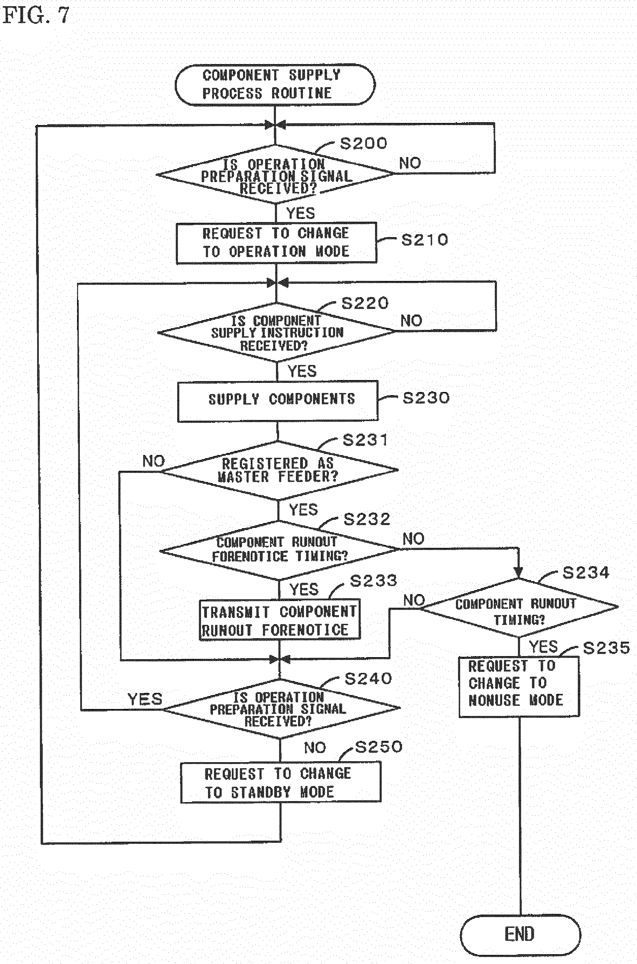

Next, a component supply process routine that is performed by each feeder controller 76 will be described by using the flowchart of Fig. 7. This component supply process routine is the same as the component supply process routine of the first embodiment except that steps S231 to S235 are performed between step S230 and step S240. Thus, only the steps that are different from the steps of the first embodiment will be described below.

The feeder controller 76, after supplying components in response to the component supply instruction in step S230, determines whether the self-feeder 72 is registered as a master feeder (step S231). This determination is performed by determining whether the self-feeder 72 is related to the master feeder and the spare feeder that are registered in the internal memory in step S190 above. When the self-feeder 72 is registered as a master feeder, a determination of whether the current point in time is a component runout forenotice timing is performed (step S232) . This determination is performed by determining whether the number of remaining components supplied by the self-feeder 72 reaches a predetermined threshold (for example, five or seven). The number of remaining components is computed by subtracting the number of consumed components from the number of components that are held at the start of production. When the current point in time is the component runout forenotice timing, a component runout forenotice is transmitted to the mounting machine controller 50 (step S233), and the above processes from step S240 are performed afterward. The component runout forenotice timing corresponds to "a time immediately before components of a master feeder run out" of the invention. Meanwhile, when the current point in time is not the component runout forenotice timing in step S232, a determination of whether the current point in time is a component runout timing is performed (step S234) . This determination is performed by determining whether the number of remaining components is zero. When the current point in time is the component runout timing in step S234, a request is transmitted to the mounting machine controller 50 to change the mode of the feeder 72 to the nonuse mode (step S235), and the routine ends. The mounting machine controller 50 that receives the request to change the mode of the feeder 72 to the nonuse mode stops supplying power to the feeder controller 76 and the motor 75. When the self-feeder 72 is not registered as a master feeder in step S231, or when the current point in time is not the component runout timing in step S234, the above processes from step S240 are performed.

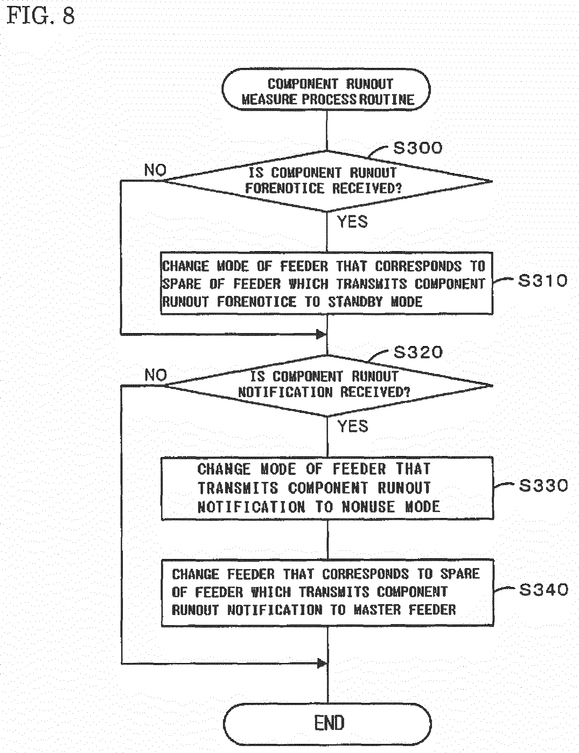

Next, a component runout measure process routine that is performed by the mounting machine controller 50 will be described by using the flowchart of Fig. 8. The component runout measure process routine starts at each predetermined timing (for example, every few sec). When the component runout measure process starts, the mounting machine controller 50 determines whether a component runout forenotice is received from any of the feeder controllers 76 (step S300). When the component runout forenotice is received, the mounting machine controller 50 changes the mode of the feeder 72 that corresponds to a spare of the feeder 72 which transmits the component runout forenotice from the nonuse mode to the standby mode (step S310) . The feeder 72 that transmits the component runout forenotice during the production is registered as a master feeder in the internal memory of the mounting machine controller 50, and thus a spare feeder that is correlated with the master feeder is also registered therein. In step S310, the mode of the spare feeder is changed from the nonuse mode to the standby mode.

After step S310, or when the component runout forenotice is not received from any of the feeders 72 in S300, a determination of whether a component runout notification is received from any of the feeder controllers 76 is performed (step S320) . When a component runout notification is received, the mode of the feeder 72 that transmits the component runout notification is changed to the nonuse mode (step S330), and the feeder 72 that is registered as the spare feeder thereof is overwritten as a master feeder (step S340). After step S340, or when the component runout notification is not received from any of the feeder controllers 76 in step S320, the routine ends.

According to the second embodiment which is described in detail thus far, the following effect is obtained in addition to the effect of the first embodiment. That is, since a master feeder and a spare feeder are prepared, it is possible to cope with a case where one feeder does not provide the entire number of one type components that are used in the current production. In that case, while the spare feeder functions as the master feeder after the components of the master feeder run out, the mode of the original master feeder is changed to the nonuse mode. Thus, power consumption can be suppressed. In addition, since the spare feeder is switched from the nonuse mode to the standby mode at the timing of the component runout forenotice, switching to the spare feeder can be smoothly performed when the components of the original master feeder run out.

### [Third Embodiment]

The component mounting system 1 of a third embodiment has the same configuration as the first embodiment. Thus, the configuration of the component mounting system 1 will not be described here, and the same constituent element will be described by using the same reference sign. In addition, the mode setting routine performed by the mounting machine controller 50 and the component supply process routine performed by the feeder controller 76 are the same as those of the second embodiment and thus will not be described here.

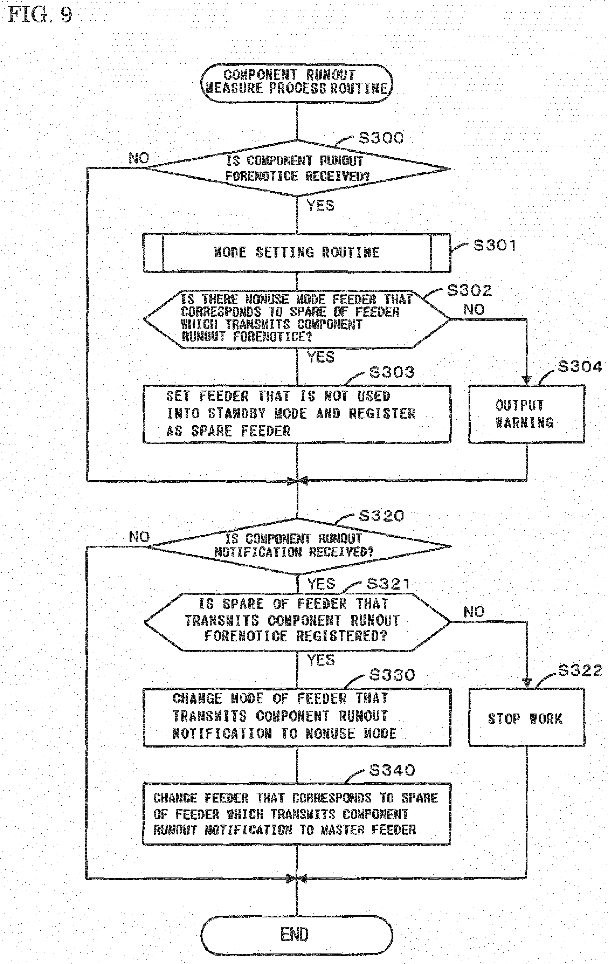

A component runout measure process routine that is performed by the mounting machine controller 50 will be described by using the flowchart of Fig. 9. This component runout measure process routine is the same as the component runout measure process routine of the second embodiment except that steps S301 to S304 are performed instead of step S310 and that steps S321 and S322 are performed between step S320 and step S330. Thus, only the steps that are different from the steps of the second embodiment will be described below.

The mounting machine controller 50, when receiving the component runout forenotice from any of the feeder controllers 76 in step S300, performs the mode setting routine described in the second embodiment (refer to Fig. 6). The mode setting routine is performed after power is supplied to all of the feeder controllers 76. Next, a determination of whether there is a nonuse mode feeder 72 that corresponds to the spare feeder of the feeder 72 which transmits the component runout forenotice is performed (step S302). When the determination is positive, the nonuse mode feeder 72 is set to the standby mode and is registered in the internal memory as the spare feeder of the feeder 72 that transmits the component runout forenotice (step S303) . Meanwhile, when the determination is negative in step S302, a warning is output to the operator (step S304) because it is not possible to cope with a component runout. The warning, for example, may be displayed as a character or sign on a not-illustrated display or may be output as a sound from a loudspeaker. The mounting machine controller 50, after step S303 or S304, proceeds to step S320. When the component runout notification is received from any of the feeder controllers 76, the mounting machine controller 50 determines whether a spare feeder is registered for the feeder 72 that transmits the component runout forenotice (step S321). When the determination is positive in step S321, the above processes from step S330 are performed. Meanwhile, when the determination is negative in step S321, the mounting work is stopped (step S322) because it is not possible to cope with a component runout, and the routine ends.

According to the third embodiment which is described in detail thus far, the following effect is obtained in addition to the effects of the first and second embodiments. That is, there may be a case where a spare feeder of feeders that are in the relationship of a master feeder and a spare feeder at the start of the current production is removed from the slot 71 or is inserted into another slot 71 during the current production. Even in such a case, the feeders 72 are checked and assigned modes again at the timing of the reception of the component runout forenotice. Thus, the spare feeder can be found, and it is possible to smoothly cope with an occurrence of a component runout.

### [Other Embodiments]

In the above embodiments, supply of power is stopped with respect to both the feeder controller 76 and the motor 75 in the nonuse mode. However, instead, power may be supplied to a communication controller circuit of the feeder controller 76, and supply of power may be stopped with respect to the remaining controller circuits of the feeder controller 76 and the motor 75. Even in doing so, power that is supplied in the nonuse mode is reduced in comparison with the standby mode.

In the above embodiments, a feeder detector that detects the insertion and removal of the feeder 72 with respect to the slot 71 may be disposed. For example, in the above third embodiment, the following process may be performed instead of steps S301 to S304 of the component runout measure process routine in Fig. 9. That is, a determination of whether a spare feeder of the feeder that transmits the component runout forenotice is inserted into the original slot is performed on the basis of a signal of the feeder detector. When the spare feeder is at the original slot, the mode of the spare feeder may be changed from the nonuse mode to the standby mode. When the spare feeder is not at the original slot, a warning may be output.

In the above second embodiment, Table 6 may be used as the production job data. In this production job, mounting is performed on 100 pieces of type α printed circuit boards 16 in the following order. Supply of the type A component is received from the feeder 72 that is inserted into the slot position #1. Next, supply of the type B component is received from the feeder 72 that is inserted into the slot position #5. Next, supply of the type C component is received from the feeder 72 that is inserted into the slot position #9. In addition, in the production job, it is determined that the feeder 72 that is inserted into the slot position #1 and the feeder 72 that is inserted into a slot position #04 are in the master-spare relationship. The former is the master feeder, and the latter is the spare feeder. In this case, steps S185 and S190 of the mode setting routine of the second embodiment (Fig. 6) may be omitted. This is because information about a master and a spare is previously determined in the production job data. Even in doing so, the routines of Fig. 7 and Fig. 8 can be performed. When the production job data of Table 6 is used, a feeder that is registered as a spare feeder is not determined to be used in the current production but determined to have a possibility of being used in the current production in the determination of whether the selected feeder is used in the current production in step S140 of the mode setting routine of Fig. 6. For example, the feeder 72 of the feeder number 05 is a spare feeder and thus is determined in step S140 to have a possibility of being used in the current production and is set into the nonuse mode.

**[Table 6]**

| Production Job Data (Number of Pieces of Boards: 100, Board Type: α) | | | |
|---|---|---|---|
| Slot Position | Component Type | Mounting Order | Master or Spare |
| #1 | A | First | Master |
| #5 | B | Second | - |
| #9 | C | Third | - |
| #6 | A | First | Spare |

In the above embodiments, the mounting machine controller 50 controls the power supply of the feeder 72. However, the management computer 80 may perform the control, or the feeder controller 76 may perform the control. In the case of the former, the management computer 80 corresponds to controlling means of the invention. In the case of the latter, the feeder controller 76 corresponds to the controlling means of the invention. A plurality of controllers and the like may share control of the power supply of the feeder 72. In that case, the plurality of controllers and the like correspond to the controlling means of the invention.

In the mode setting routine of the above embodiments, a check of whether the relationship between the slot position, the feeder number, and the component type (Table 4) obtained in step S110 matches the relationship between the slot position, the feeder number, and the component type of the production job (Table 1) may be performed. When the relationships do not match, a warning may be output.

In the above embodiments, the component mounting system 1 is described as being provided with the plurality (four) of component mounting machines 11. However, the component mounting system 1 may be provided with one component mounting machine 11.

In the above embodiments, the mode setting routine starts when the mode setting start button is switched ON. However, the mode setting routine may automatically start with switching of the production job or setting of the feeder as a trigger. When setting of the feeder is used as a trigger, the mode setting routine may be performed on only the feeder that is set.

In the above second and third embodiments, the feeder that has a possibility of being used in the current production (spare feeder) is set to the nonuse mode in the mode setting routine (steps S140 and S160) . However, the feeder may be set to the standby mode.

In the above embodiments, the feeder that is used in the current production is set to the standby mode in the mode setting routine (steps S140 and S150). However, the feeder may be set into the operation mode. In this case, the two modes that the feeder can have are the nonuse mode and the operation mode.

### Industrial Applicability

The invention may be used in a component mounting machine and the like that mount components on a printed circuit board.

### Reference Signs List

1: COMPONENT MOUNTING SYSTEM, 11: COMPONENT MOUNTING MACHINE, 16: PRINTED CIRCUIT BOARD, 18: BOARD CONVEYANCE DEVICE, 20: SUPPORTING BOARD, 22: CONVEYOR BELT, 24: HEAD, 26: X-AXIS SLIDER, 28: GUIDE RAIL, 30: Y-AXIS SLIDER, 32: GUIDE RAIL, 34 Z-AXIS MOTOR, 36: BALL SCREW, 40: SUCTION NOZZLE, 50: MOUNTING MACHINE CONTROLLER, 70: REEL UNIT, 71: SLOT, 72: FEEDER, 73: REEL, 74: SPROCKET, 75: MOTOR, 76: FEEDER CONTROLLER, 77: FEEDER CONNECTOR, 78: SLOT CONNECTOR, 80: MANAGEMENT COMPUTER, 82: PERSONAL COMPUTER MAIN BODY, 84: INPUT DEVICE, 86: DISPLAY

## Claims

1. A feeder power supply control device that controls power supply of an electric feeder which sequentially supplies components to a component mounting machine (11),
the device **characterized by** comprising:
determining means for determining whether the feeder (72) is used in a current production; and
controlling means for reducing power supplied to the feeder (72) that has no possibility of being used in the current production in comparison with the feeder (72) that is used in the current production.

2. The feeder power supply control device according to Claim 1,
wherein the controlling means sets the feeder (72) that is used in the current production to a non-power saving mode in which the feeder (72) is capable of supplying components in response to a component supply instruction and sets the feeder (72) that has no possibility of being used in the current production to a power saving mode in which power supplied is low in comparison with the non-power saving mode.

3. The feeder power supply control device according to Claim 2,
wherein the controlling means, when there is a feeder (72) that supplies the same components as the feeder (72) that is used in the current production among the feeders, sets the feeder (72) that is used in the current production as a master feeder that immediately supplies components to the component mounting machine (11), sets the feeder (72) that supplies the same components as the master feeder as a spare feeder that is used as a spare when components of the master feeder run out and that has a possibility of being used in the current production, sets the spare feeder to the power saving mode, and changes the mode of the spare feeder to the non-power saving mode immediately before components of the master feeder run out and then changes the mode of the master feeder to the power saving mode when components of the master feeder run out.

4. The feeder power supply control device according to Claim 2 or 3,
wherein the power saving mode is a mode in which all power supplies to the feeders are switched OFF.

5. A feeder power supply control method for controlling power supply of an electric feeder that sequentially supplies components to a component mounting machine (11),
the method **characterized by** comprising:
a step of determining whether the feeder (72) is used in a current production; and
a step of reducing power supplied to the feeder (72) that has no possibility of being used in the current production in comparison with the feeder (72) that is used in the current production.

## Patentansprüche

1. Stromversorgungssteuerungsvorrichtung, die die Stromversorgung einer elektrischen Zuführung steuert, die nacheinander Komponenten an eine Komponentenbestückungsmaschine (11) liefert,
wobei die Vorrichtung **dadurch gekennzeichnet ist, dass** sie umfasst:
eine Bestimmungseinrichtung zum Bestimmen, ob die Zuführung (72) in einer laufenden Produktion verwendet wird; und
eine Steuerungseinrichtung zum Reduzieren der Energie, die der Zuführung (72) geliefert wird, die keine Möglichkeit hat, um in der laufenden Produktion verwendet zu werden, im Vergleich mit der Zuführung (72), die in der laufenden Produktion verwendet wird.

2. Stromversorgungssteuerungsvorrichtung nach Anspruch 1,
wobei die Steuerungseinrichtung die Zuführung (72), die in der laufenden Produktion verwendet wird, in einen Nichtenergiesparmodus einstellt, in dem die Zuführung Komponenten in Reaktion auf eine Komponentenlieferanweisung liefern kann, und die Zuführung (72), die keine Möglichkeit hat, in der laufenden Produktion verwendet zu werden, in einen Energiesparmodus einstellt, in dem die gelieferte Energie im Vergleich mit dem Nichtenergiesparmodus niedrig ist.

3. Stromversorgungssteuerungsvorrichtung nach Anspruch 2,
wobei die Steuerungseinrichtung, wenn es eine Zuführung (72) gibt, die die gleichen Komponenten wie die Zuführung (72) unter den Zuführungen liefert, die bei der laufenden Produktion verwendet wird, die bei der laufenden Produktion verwendete Zuführung (72) als eine Hauptzuführung einstellt, die der Komponentenbestückungsmaschine (11) Bauteile sofort liefert, die Zuführung (72), die die gleichen Komponenten wie die Hauptzuführung liefert, als eine Ersatzzuführung einstellt, die als Ersatz verwendet wird, wenn Komponenten der Hauptzuführung ausgehen, und die eine Möglichkeit hat, in der laufenden Produktion verwendet zu werden, die Ersatzzuführung auf den Energiesparmodus einstellt und den Modus der Ersatzzuführung auf den Nichtenergiesparmodus ändert, unmittelbar bevor Komponenten der Hauptzuführung ausgehen, und dann den Modus der Hauptzuführung auf den Energiesparmodus ändert, wenn Komponenten der Hauptzuführung ausgehen.

4. Stromversorgungssteuerungsvorrichtung nach Anspruch 2 oder 3,
wobei der Energiesparmodus ein Modus ist, in dem alle Stromversorgungen für die Zuführungen abgeschaltet sind.

5. Stromversorgungssteuerungsverfahren zum Steuern der Stromversorgung einer elektrischen Zuführung, die nacheinander Komponenten an eine Komponentenbestückungsmaschine (11) liefert,
wobei das Verfahren **dadurch gekennzeichnet ist, dass** es umfasst:
einen Schritt zum Bestimmen, ob die Zuführung (72) in einer laufenden Produktion verwendet wird; und
einen Schritt zum Reduzieren der Energie, die der Zuführung (72) geliefert wird, die keine Möglichkeit hat, in der laufenden Produktion verwendet zu werden, im Vergleich mit der Zuführung (72), die in der laufenden Produktion verwendet wird.

## Revendications

1. Dispositif de commande d'alimentation en énergie de distributeur qui commande l'alimentation en énergie d'un distributeur électrique qui fournit séquentiellement des composants à une machine de montage de composants (11),
le dispositif étant **caractérisé en ce qu'**il comprend :
des moyens de détermination pour déterminer si le distributeur (72) est utilisé lors d'une production courante ; et
des moyens de commande pour réduire l'énergie fournie au distributeur (72) qui n'a aucune possibilité d'être utilisé pendant la production courante par comparaison au distributeur (72) qui est utilisé pendant la production courante.

2. Dispositif de commande d'alimentation en énergie de distributeur selon la revendication 1,
dans lequel les moyens de commande établissent le distributeur (72) qui est utilisé pendant la production courante dans un mode sans économie d'énergie dans lequel le distributeur (72) est capable de fournir des composants en réponse à une instruction d'alimentation en composants et établissent le distributeur (72) qui n'a aucune possibilité d'être utilisé pendant la production courante dans un mode d'économie d'énergie dans lequel l'énergie alimentée est faible par comparaison au mode sans économie d'énergie.

3. Dispositif de commande d'alimentation en énergie de distributeur selon la revendication 2,
dans lequel les moyens de commande, lorsqu'il y a un distributeur (72) qui fournit les mêmes composants que le distributeur (72) qui est utilisé pendant la production courante parmi les distributeurs, établissent le distributeur (72) qui est utilisé pendant la production courante en tant que distributeur principal qui fournit immédiatement des composants à la machine de montage de composants (11), définissent le distributeur (72) qui fournit les mêmes composants que le distributeur principal en tant que distributeur d'appoint qui est utilisé comme appoint lorsque des composants du distributeur principal viennent à manquer et qui a une possibilité d'être utilisé pendant la production courante, établissent le distributeur d'appoint en mode d'économie d'énergie, et changent le mode du distributeur d'appoint en mode sans économie d'énergie immédiatement avant que des composants du distributeur principal ne viennent à manquer, puis changent le mode du distributeur principal en mode d'économie d'énergie lorsque des composants du distributeur principal viennent à manquer.

4. Dispositif de commande d'alimentation en énergie de distributeur selon la revendication 2 ou 3,
dans lequel le mode d'économie d'énergie est un mode dans lequel toutes les alimentations en énergie des distributeurs sont désactivées.

5. Procédé de commande d'alimentation en énergie de distributeur pour commander l'alimentation en énergie d'un distributeur électrique qui fournit séquentiellement des composants à une machine de montage de composants (11),
le procédé étant **caractérisé en ce qu'**il comprend :
une étape consistant à déterminer si le distributeur (72) est utilisé pendant une production courante ; et
une étape de réduction d'énergie fournie au distributeur (72) qui n'a aucune possibilité d'être utilisé pendant la production courante par comparaison au distributeur (72) qui est utilisé pendant la production courante.
